# EUROPÄISCHE PATENTSCHRIFT

(11) **EP 1 204 152 B1**
(45) Veröffentlichungstag und Bekanntmachung des Hinweises auf die Patenterteilung: **17.05.2006**
(21) Anmeldenummer: 01126097.3
(22) Anmeldetag: 02.11.2001
(51) Int. Cl.: H01L 41/047, H01L 41/083

(54) **Aussenelektroden an piezokeramischen Vielschichtaktoren**
External electrodes for piezoceramic stack actuators
Electrodes extérieures pour actionneurs piézocéramiques multicouche

(30) Priorität: 06.11.2000 DE 10054735; 24.10.2001 DE 10152490
(43) Veröffentlichungstag der Anmeldung: 08.05.2002
(73) Patentinhaber: CeramTec AG Innovative Ceramic Engineering, 73207 Plochingen (DE)
(72) Erfinder: Bindig, Reiner, 95463 Bindlach (DE); Schreiner, Hans-Jürgen, Dr., 91233 Neunkirchen am Sand-Rollhofen (DE)
(74) Vertreter: Scherzberg, Andreas Hans

(56) Entgegenhaltungen:
- EP-A- 0 427 901
- EP-A- 0 655 790
- DE-A- 3 940 619
- DE-A- 4 224 284
- DE-A- 19 860 001
- DE-A- 19 928 178
- US-A- 4 523 121
- US-A- 5 406 164

## Beschreibung

Die Erfindung betrifft einen piezokeramischen Vielschichtaktor mit Außenelektroden sowie ein Verfahren zu seiner Herstellung.

Der Aufbau und die Herstellung von Aktoren und ihren Außenelektroden wird unter anderem ausführlich beschrieben in DE 33 30538 A1, DE 40 36 287 C2, US 5 281 885, US 4 845 399, US 5 406 164 und JP 07-226541 A.

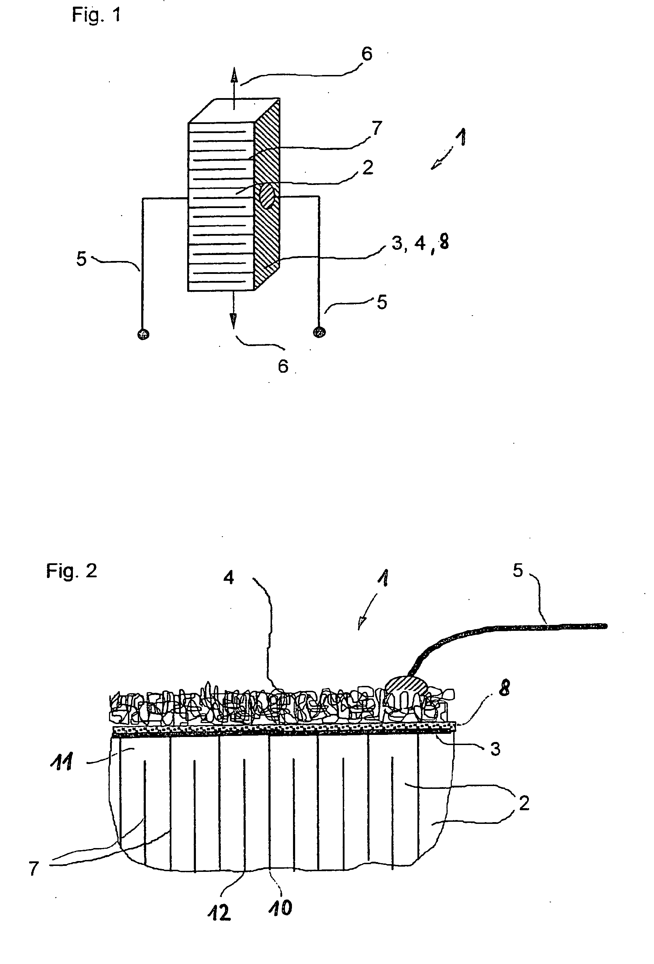

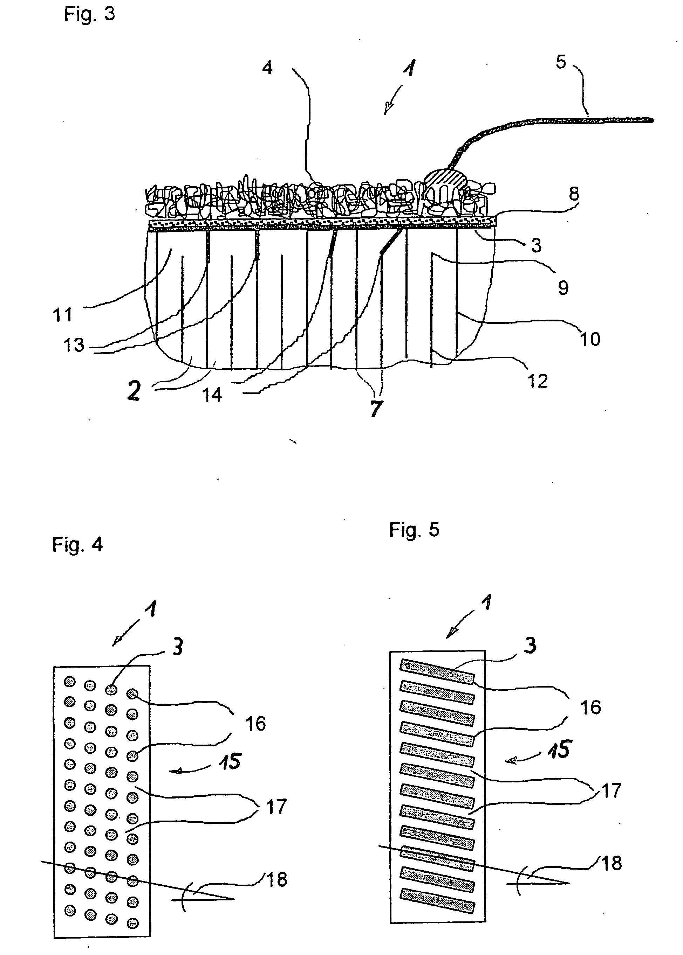

Ein piezokeramischer Vielschichtaktor ist schematisch in Figur 1 dargestellt. Die Figur 2 zeigt in einem vergrößerten Ausschnitt den Aufbau der Außenelektrode nach dem Stand der Technik und die Figur 3 einen typischen Rissverlauf nach 10⁶ Belastungszyklen in dem keramischen Werkstoff unter einer Außenelektrode nach dem Stand der Technik. Piezokeramische Vielschichtaktoren 1 werden als Monolithen ausgeführt, das heißt, sie bestehen aus gestapelten dünnen Schichten 2 piezoelektrisch aktiven Materials, beispielsweise Blei-Zirkonat-Titanat (PZT), mit dazwischen angeordneten leitfähigen Innenelektroden 7, die alternierend an die Aktoroberfläche geführt werden. Das aktive Material wird als sogenannte Grün-Folie vor dem Sintern durch ein Siebdruckverfahren mit Innenelektroden 7 versehen, zu einem Stapel verpresst, pyrolysiert und dann gesintert, wodurch ein monolithischer Vielschichtaktor 1 entsteht.

Außenelektroden 3, 4, 8 verbinden die Innenelektroden 7. Dadurch werden die Innenelektroden 7 jeweils auf einer Seite des Aktors 1 elektrisch parallel geschaltet und so zu einer Gruppe zusammengefasst. Die Außenelektroden 3, 4 sind die Anschlusspole des Aktors. Wird eine elektrische Spannung an die Anschlusspole gelegt, so wird diese auf alle Innenelektroden 7 parallel übertragen und verursacht ein elektrisches Feld in allen Schichten des aktiven Materials, das sich dadurch mechanisch verformt. Die Summe aller dieser mechanischen Verformungen steht an den Endflächen des Aktors als nutzbare Dehnung 6 und/oder Kraft zur Verfügung.

Die Außenelektroden 3, 4, 8 an den piezokeramischen Vielschichtaktoren 1 sind wie folgt aufgebaut: Auf die zu einem Stapel gepressten dünnen Schichten 2 des piezoelektrisch aktiven Materials wird im Bereich der herausgeführten Innenelektroden 10, beispielsweise durch galvanische Verfahren oder Siebdruck von Metallpaste, eine Grundmetallisierung 3 aufgebracht. Diese Grundmetallisierung 3 wird durch eine weitere Schicht 4 aus einem metallischen Werkstoff verstärkt, beispielsweise durch ein strukturiertes Blech oder ein Drahtnetz. Die Verbindung der Verstärkungsschicht 4 mit der Grundmetallisierung 3 erfolgt beispielsweise mittels einer Lotschicht 8. An die Verstärkungsschicht 4 wird der elektrische Anschlussdraht 5 gelötet.

Derart aufgebaute Außenelektroden weisen einen gravierenden Nachteil auf. Während des Betriebes wirken auf den Isolierbereich 11, der unter der Grundmetallisierung 3 liegt, starke Zugspannungen. Da dieser Isolierbereich 11 zusammen mit der Grundmetallisierung 3 und der Verbindungsschicht 8, in der Regel eine Lotschicht, eine homogene Einheit bildet, versagt diese beim Überschreiten der Zugfestigkeit des schwächsten Gliedes und es bilden sich Risse. Die Risse laufen gewöhnlich von der spröden und wenig zugfesten Grundmetallisierung 3 in den Isolierbereich 11 und werden dort von Bereichen mit hohen Zugspannungen eingefangen, bevorzugt an den Elektrodenspitzen 9 der nicht die Grundmetallisierung 3 berührenden Elektroden 12, oder sie beginnen in den Bereichen maximaler Zugspannung an den Elektrodenspitzen 9 und verlaufen in Richtung Grundmetallisierung 3. Diese typischen Risse 14 sind in Fig. 3 dargestellt.

Die Ausbreitung eines Risses 13 entlang einer die Grundmetallisierung 3 berührenden Innenelektrode 10 ist als unkritisch einzustufen, da ein solcher Rissverlauf die Funktion des Aktors nicht beeinträchtigt. Risse 14 dagegen, die unkontrolliert durch den Isolierbereich 11 verlaufen, sind sehr kritisch, da sie den Isolationsabstand verringern und die Wahrscheinlichkeit eines Aktorausfalls durch Überschläge stark erhöhen.

Problemlösungen werden zum Beispiel in den Patentanmeldungen DE 198 60 001 A1, DE 394 06 19 A1, DE 196 05 214 A1 beschrieben. Es wird dort vorgeschlagen, den Bereich zwischen einer nicht die Grundmetallisierung berührenden Elektrode und der Grundmetallisierung mit einem Füllmaterial geringer Zugfestigkeit oder einem Hohlraum zu versehen. Die wesentlichen Nachteile dieser Vorgehensweise sind darin zu sehen, dass das Füllmaterial mit einem zusätzlichen, komplexen Verfahrensschritt aufgebracht werden muss, dass das Füllmaterial unvermeidbar die Eigenschaften der Aktors negativ beeinflusst und im Falle der eingebrachten Hohlräume diese in einem weiteren Verfahrensschritt vor dem Aufbringen der Grundmetallisierung wieder geschlossen werden müssen.

Eine andere Problemlösung wird in DE 199 28 178 A1 vorgeschlagen. Hier wird der monolithische Aufbau in kleine Teilbereiche zerlegt und alternierend mit inaktiven, elektrodenfreien Bereichen wieder aufgebaut. Hierbei soll innerhalb eines aktiven Bereiches die maximal mögliche Zugspannung unterhalb des zur Rissbildung notwendigen Wertes bleiben. Das Verfahren ist fertigungstechnisch schwierig und führt nicht zur notwendigen Reduktion der Spannungen im Isolierbereich, so dass immer eine latente Rissgefahr bestehen bleibt.

Aufgabe der Erfindung ist es, die Außenelektroden an Vielschichtaktoren so zu gestalten, dass die Ursachen zur Rissbildung in den Aktoren möglichst vermieden werden und dass beim Auftreten von Rissen deren Verlauf so gesteuert wird, dass er nicht zur Zerstörung der Aktoren führt.

Die Lösung der Aufgabe erfolgt erfindungsgemäß wie durch Anspruch 1 definiert dadurch, dass die Grundmetallisierung der Außenelektrode nicht mehr eine geschlossene Fläche bildet, sondern strukturiert ist, wobei die Strukturierung durch Unterbrechungen oder Ausnehmungen gebildet wird. Weitere vorteilhafte Ausgestaltungen der Erfindung werden in den abhängigen Ansprüchen beansprucht.

Durch die Strukturierung der Grundmetallisierung in der Außenelektrode wird die Steifigkeit des Verbundes, bestehend aus Keramikoberfläche, Grundmetallisierung und Verbindungsschicht, insgesamt herabgesetzt, wodurch bei auftretenden Rissen Vorzugsrichtungen für die Rissausbreitung erzeugt werden. Die Strukturierung bewirkt, dass die mechanische Rückwirkung der Außenelektrode auf den Aktor und damit auch der Risseintrag verringert wird, ohne die Haftfestigkeit der Außenelektrode und die sichere Kontaktierung der Innenelektroden zu gefährden.

Die durch die Strukturierung der Grundmetallisierung müssen allerdings Flächen verbleiben, die mindestens so groß sind, dass jeweils benachbarte Innenelektroden durch mindestens eine Fläche miteinander verbunden sind.

Weiterhin entstehen durch die Unterbrechung der Grundmetallisierung in der Außenelektrode an der Aktoroberfläche Bereiche, in denen zwischen der Verbindungsschicht, die die Verstärkungsschicht mit der Grundmetallisierung verbindet, insbesondere bei einer Lotschicht, und den nach außen führenden Innenelektroden eine Wechselwirkung stattfindet. Durch die Unterbrechungen in der Struktur der Grundmetallisierung kann beim Auflöten der Verstärkungsschicht Metall aus dem Lot in die Innenelektroden einlegiert werden. Die Folge ist, dass die Isolierbereiche an diesen Stellen geschwächt werden, wodurch Vorzugsstellen für mögliche Rissbildungen und den Rissverlauf entstehen. Durch die Steuerung von Lötzeit und Löttemperatur kann der Eindringeffekt so eingestellt werden, dass beim späteren Betrieb des Aktors nahezu jede Innenelektrode zur Leitfläche für einen entstehenden Riss wird. Das Gefüge des Isolierbereichs wird dadurch maximal entspannt, die Risse bleiben ungefährlich, es können sich keine Risse mehr bilden, die durch den Keramikwerkstoff verlaufen. Zur Durchführung im Fertigungsprozess wird kein zusätzlicher Verfahrensschritt benötigt. Aufgrund der geringen Prozesstemperatur beim Löten wird der Keramikwerkstoff nicht geschädigt.

Bei Vielschichtaktoren mit der erfindungsgemäß strukturierten Grundmetallisierung erfolgt deshalb eine Rissbildung ausschließlich entlang der nach außen führenden Innenelektroden, die vorteilhaft unkritisch ist, weil sie die Funktion des Aktors nicht beeinträchtigt.

Anhand von Ausführungsbeispielen wird die Erfindung näher erläutert. Es zeigen:
- Fig. 4: eine Grundmetallisierung, die mittels Siebdruck mit einer Terminierungspaste erzeugt worden ist, mit einer erfindungsgemäßen Struktur aus einzelnen punktförmigen Flächen,
- Fig. 5: mit einer erfindungsgemäßen Struktur aus einzelnen Linien,
- Fig. 6: mit einer erfindungsgemäßen netzartigen Struktur und
- Fig. 7: mit einer erfindungsgemäßen Struktur, die aus einer vollflächig gedruckten Metallisierung durch mechanisches Abtragen herausgearbeitet worden ist.

Der schematische Aufbau der hier eingesetzten Vielschichtaktoren entspricht dem in Figur 1 dargestellten. Die erfindungsgemäßen Außenelektroden unterscheiden sich von der in den Figuren 2 und 3 dargestellten Außenelektrode durch die Strukturierung der Grundmetallisierung.

Die erfindungsgemäße Strukturierung der Grundmetallisierung wurde an fünf Ausführungsbeispielen geprüft. Dazu wurden zunächst Grundkörper von Vielschichtaktoren entsprechend Figur 1 hergestellt, auf denen in unterschiedlichen Mustern die Grundmetallisierung aufgebracht wurde. Danach wurden die Außenelektroden der Aktoren vervollständigt.

Die Herstellung von Grundkörpern der Aktoren erfolgt wie nachstehend beschrieben: Aus einem niedrig sinternden piezokeramischen Werkstoff, beispielsweise SKN53 nach DE 198 40 488 A1, wird mit einem organischen Bindersystem eine 125 µm dicke Folie präpariert. Auf diese Folie wird eine Innenelektrodenpaste aus Silber-Palladium-Pulver in einem Gewichtsverhältnis von 70/30 und einem geeigneten Bindersystem mittels Siebdruck aufgebracht. Eine Vielzahl derartiger Folien wird gestapelt und zu einem Laminat verpresst. Das Laminat wird in einzelne, stabförmige Aktoren getrennt, diese werden bei etwa 400 °C pyrolysiert und bei etwa 1100 °C gesintert. Anschließend werden die Aktorgrundkörper an allen Seiten mechanisch bearbeitet.

Die Grundmetallisierung 3, beispielsweise aus einer geeigneten Silber-Palladium-Terminierungspaste, wird mittels Siebdruck aufgebracht, wobei dadurch eine Struktur 15 entsteht, dass die bedruckten Flächen 16 von unbedruckten Flächen 17 unterbrochen sind, wie es in den Figuren 4 bis 6 dargestellt ist. Anschließend erfolgt der Einbrennprozess. Das entstehende punkt-, linien- oder netzartige Raster 15 aus bedruckten Flächen 16 soll so fein wie möglich sein, wobei sichergestellt sein muss, dass jeweils benachbarte Innenelektroden 10, die entsprechend Figur 2 an die Oberfläche des Aktors 1 führen, durch mindestens eine aufgedruckte Fläche 16 miteinander verbunden werden. Um das zu erreichen ist es sinnvoll, das Raster 15 unter einem Winkel, in den Figuren 4 bis 6 mit 18 gekennzeichnet, gegenüber der Richtung der Innenelekroden 10 verlaufen zu lassen. Wird die Struktur zu fein, so sinkt die Festigkeit des Verbundes zur später aufgebrachten Verstärkungsschicht, beispielsweise einer aufgelöteten Netzelektrode. Bei einem Abstand der Innenelektroden 10 von 100 µm hat sich als besonders vorteilhaft ein bedruckter Bereich 16 der Grundmetallisierung 3 von 0,2 bis 0,3 mm mit gleich großen Unterbrechungen 17 erwiesen.

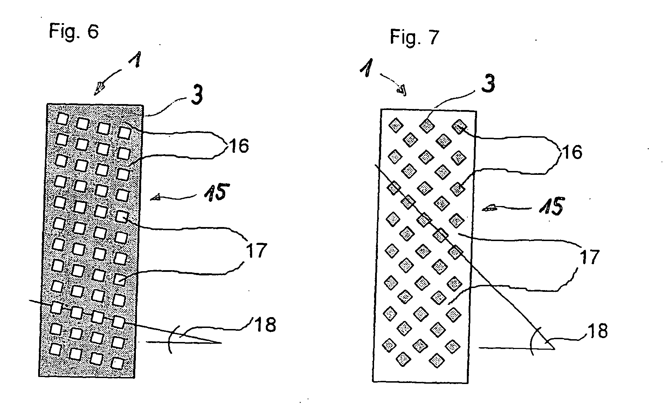

Die Grundmetallisierung kann auch durch örtliches mechanisches Abtragen einer ganzflächig aufgetragenen Schicht strukturiert werden, beispielsweise durch Einsägen oder Einritzen. Die Struktur kann weiterhin durch einen elektrochemischen Prozess erzeugt werden, wobei die Tatsache genutzt wird, dass elektrochemisch abgeschiedene Metalle porös sind. Eine derart erzeugte Struktur 15 ist in Figur 7 dargestellt.

Nach dem Einbrennen der Grundmetallisierung werden die Außenelektroden durch die Verstärkungsschicht vervollständigt, beispielsweise durch das Auflöten eines Metalldraht-Netzes. Anschließend können die Aktoren polarisiert und ihre Eigenschaften gemessen werden.

Nachstehend werden Proben von vier Ausführungsbeispielen mit erfindungsgemäßen Außenelektroden mit Proben mit Außenelektroden nach dem Stand der Technik verglichen.

Die Aktorgrundkörper der Proben, die entsprechend dem oben beschriebenen Verfahren hergestellt worden sind, haben Abmessungen von 10 x 10 mm² Grundfläche und 30 mm Höhe. Die Dicke einer Keramikeinzellage beträgt nach dem Sintern 100 µm, die Dicke einer Innenmetallisierungsschicht 2 µm. Die Aktorgrundkörper werden wie folgt weiterbehandelt:

Für Aktoren nach dem Stand der Technik als Referenz wird die Grundmetallisierung 3 aus einer geeigneten AgPd Terminierungspaste mittels Siebdruck aufgebracht, wobei keine Struktur erzeugt wird. Die Schicht ist gleichmäßig dick, die Schichtdicke beträgt 8 µm nach dem Einbrennen bei 800 °C.

Für das erste Ausführungsbeispiel wird die Grundmetallisierung 3 aus einer geeigneten AgPd Terminierungspaste mittels Siebdruck aufgebracht, wobei eine rasterartige Struktur 15 aus runden punktförmigen Flächen 16 erzeugt wird, vergleichbar dem Muster in Figur 4. Der Durchmesser dieser Flächen beträgt 0,2 mm, der Freiraum 17 zwischen zwei Flächen ebenfalls 0,2 mm. Das Raster 15 ist unter einem Winkel 18 von 20° zur Richtung der Innenelektroden 10 geneigt, wenn ein Schenkel des Winkels durch die hintereinanderliegenden punkförmigen Flächen gelegt wird, so dass jeweils benachbarte Innenelektroden 10 durch mindestens eine aufgedruckte Fläche 16 miteinander verbunden werden. Die Schicht der punkförmigen Flächen ist gleichmäßig dick, die Schichtdicke beträgt 9 µm nach dem Einbrennen bei 800 °C.

Für das zweite Ausführungsbeispiel wird die Grundmetallisierung 3 aus einer geeigneten AgPd Terminierungspaste mittels Siebdruck aufgebracht, wobei eine linienartige Struktur 15 erzeugt wird, vergleichbar dem Muster in Figur 5. Die Breite der Linienstrukturen 16 beträgt 0 2 mm, der Abstand 17 zwischen zwei Linienstrukturen beträgt ebenfalls 0,2 mm. Die Linienstrukturen 16 sind, wie beim ersten Ausführungsbeispiel, unter einem Winkel 18 gegenüber der Richtung der Innenelektroden 10 geneigt, wenn ein Schenkel des Winkels durch die Linienstruktur verläuft. Die Schicht der Linienstruktur 15 ist gleichmäßig dick, die Schichtdicke beträgt 9 µm nach dem Einbrennen bei 800 °C.

Für das dritte Ausführungsbeispiel wird die Grundmetallisierung 3 aus einer geeigneten AgPd Terminierungspaste mittels Siebdruck aufgebracht, wobei keine Struktur erzeugt wird. Die Schicht ist gleichmäßig dick, die Schichtdicke beträgt 8 µm nach dem Einbrennen bei 800 °C. In der Grundmetallisierung 3 wird ein Raster 15 aus Quadraten 16 erzeugt, indem mittels einer Diamantsäge die Schicht in 0,2 mm große Quadrate 16 aufgetrennt wird, vergleichbar dem Muster in Figur 7. Der Abstand 17 der Quadrate 16 beträgt 0,1 mm. Die Verbindungslinien der in einer Reihe hintereinanderliegenden Quadrate im Raster 15 verlaufen unter einem Winkel 18 von 35° zur Richtung der Innenelektroden, damit jeweils benachbarte Innenelektroden durch mindestens ein Quadrat überdeckt werden.

Für das fünfte Ausführungsbeispiel, das hier nicht dargestellt ist, wird die Grundmetallisierung elektrochemisch in Form einer Nickelschicht abgeschieden. Die Nickelschicht ist etwa 2 µm dick und wird von einer ebenfalls elektrochemisch abgeschiedenen, 0,1 µm dicken Goldschicht überdeckt. Die Goldschicht verbessert die Lötfähigkeit und hat keine andere Funktion. Die Nickelschicht ist verfahrensbedingt nicht völlig geschlossen und hat eine feine netzartige Struktur, wobei Durchbrüche in der Größenordnung des Keramikkorns liegen, etwa zwischen 5 und 10 µm.

Auf die fünf Ausführungsbeispiele werden anschließend mit einem geeigneten Prozess die Außenelektroden durch ein aufgelötetes Drahtnetz vervollständigt. Als Netzwerkstoff wird ein dem thermischen Ausdehnungskoeffizienten der Keramik vergleichbarer Werkstoff, beispielsweise FeNi₃₆, verwendet. Der Drahtdurchmesser beträgt 100 µm, die Maschenweite 200 µm. Das Netz ist galvanisch vorbehandelt, beispielsweise verkupfert, um die Lötbarkeit zu verbessern. Als Lot wird SnAg₄ verwendet. Die Lötzeit beträgt 10 Minuten bei 240 °C.

Nach dem Löten ist optisch erkennbar, dass bei den Varianten 2 bis 5 der Ausführungsbeispiele das Lot die Innenelektroden auch auf den nicht mit Grundmetallisierung versehenen Flächen benetzt hat.

Die Aktoren werden gereinigt und mit einer geeigneten Lackierung isoliert. Nach dem Anlöten der Anschlussdrähte an die Elektrodennetze werden die Aktoren in Prüfrahmen mit 2000 N vorgespannt und mit einem Trapezsignal angesteuert. Dabei wird die Ansteuerspannung in 100 µs von 0 V auf 200 V angehoben, 1 ms auf 200 V gehalten, und dann in 100 µs auf 0 V erniedrigt. Die Wiederholfrequenz ist 200 Hz. Die Aktoren erreichen dabei Betriebstemperaturen von 150 bis 160 °C.

Die Variante 1 zeigt bereits bei 10⁶ Zyklen eine deutliche und starke Rissbildung. Die Risse durchtrennen die Isolierzone in beliebigen Richtungen, Risse entlang der Innenelektroden sind eher selten.

Die Varianten 2 und 3 zeigen nahezu identisches Verhalten, das sich von Variante 1 deutlich unterscheidet. Bei 10⁶ Zyklen tritt eine kaum sichtbare Rissbildung auf. Bei 10⁷ Zyklen tritt Rissbildung auf. Die Risse verlaufen alle entlang der Innenelektroden, treten etwa doppelt so häufig auf wie bei der Variante 1, sind aber deutlich schwächer ausgeprägt. Auch nach 10⁸ Zyklen bleibt dieser Zustand unverändert.

Die Variante 4 zeigt das günstigste Rissverhalten. Erst ab 10⁸ Zyklen tritt deutliche Rissbildung auf. Die Risse verlaufen ebenfalls alle entlang der Innenelektroden. Bei dieser Variante scheren jedoch die Quadrate des Quadrat-Rasters 16 leicht von der Keramik ab. Die Ursache lag darin, dass der Übergang zwischen Grundmetallisierung und Keramik beim Sägeprozess am Rand der Quadrate geschädigt wurde. Durch optimieren der Trennschnitte in der Grundmetallisierung kann eine Beschädigung des Keramikwerkstoffs vermieden werden. Durch geeignete Ätzverfahren kann eine Beschädigung des Keramikwerkstoffs ebenfalls vermieden werden.

Die Variante 5 zeigt ein Rissverhalten wie die Varianten 2 und 3, jedoch ist die Haftfestigkeit des Nickels auf der Keramik nicht ausreichend. Es treten nach und nach örtlich Ablösungen der Grundmetallisierung von der Keramik auf, wodurch die Funktion des Aktors bei langen Laufzeiten beeinträchtigt werden kann.

## Patentansprüche

1. Piezokeramischer Vielschichtaktor (1), bestehend aus einem monolithischen, in einem Stück gefertigten Laminatgrundkörper, aufgebaut aus sich abwechselnden Schichten von piezokeramischen Werkstoff (2) und dazwischen liegenden Innenelektroden (10) und Außenelektroden (3, 4, 8), die an denjenigen Außenflächen des Laminatgrundkörpers, an denen die Innenelektroden (10) alternierends an die Oberfläche des Laminatgrundkörpers treten, aufgetragen sind und aus einer Grundmetallisierungsschicht (3) unmittelbar auf der Oberfläche des Laminatgrundkörpers und einer Verstärkungsschicht (4), die mittels einer dazwischenliegenden Verbindungsschicht (8) auf der Außenfläche der Grundmetallisierungsschicht (3) verbunden ist, bestehen, die Grundmetallisierungsschicht (3), die Verbindungsschicht (8) und die Verstärkungsschicht (4) unmittelbar in dieser Reihenfolge aufeinander aufgetragen sind und an der Verstärkungsschicht (4) ein Anschlussdraht (5) angelötet ist, **dadurch gekennzeichnet, dass** die Grundmetallisierungsschicht eine (3) durch Unterbrechungen oder Ausnehmungen (17) definierte Struktur aufweist.

2. Piezokeramischer Vielschichtaktor nach Anspruch 1, **dadurch gekennzeichnet, dass** die Struktur (15) der Grundmetallisierung (3) aus einem Druckmuster einer geeigneten Terminierungspaste besteht, das mittels eines Druckverfahrens erzeugt worden ist.

3. Piezokeramischer Vielschichtaktor nach Anspruch 1, **dadurch gekennzeichnet, dass** die Struktur (15) der Grundmetallisierung (3) durch einen mechanischen, chemischen oder elektrochemischen Abtrag in einer vollflächig aufgetragenen Schicht der Grundmetallisierung (3) gebildet ist.

4. Piezokeramischer Vielschichtaktor nach Anspruch 2 oder 3, **dadurch gekennzeichnet, dass** die Grundmetallisierung (3) aus einer geeigneten Terminierungspaste besteht, die die Zusammensetzung AgₓPd_{y} aufweist, wobei x + y = 1 und 1 > x > 0 sind, vorzugsweise aber 1 > x > 0,7 ist.

5. Piezokeramischer Vielschichtaktor nach Anspruch 1, **dadurch gekennzeichnet, dass** die Struktur (15) der Grundmetallisierung (3) durch eine poröse elektrochemische Abscheidung eines geeigneten metallischen Werkstoffs gebildet ist.

6. Piezokeramischer Vielschichtaktor nach Anspruch 5, **dadurch gekennzeichnet, dass** der metallische Werkstoff Nickel ist.

7. Piezokeramischer Vielschichtaktor nach einem der Ansprüche 1 bis 6, **dadurch gekennzeichnet, dass** die Struktur (15) der Grundmetallisierung (3) aus über die Oberfläche des Aktors (1) angeordnete Flächen (16) besteht und dass die Flächen (16) mindestens so groß sind, dass jeweils benachbarte Innenelektroden (10) durch mindestens eine Fläche (16) miteinander verbunden sind.

8. Piezokeramischer Vielschichtaktor nach einem der Ansprüche 1 bis 7, **dadurch gekennzeichnet, dass** die Struktur (15) der Grundmetallisierung (3) eine rasterartige Struktur aus punktförmigen Flächen (16) ist, dass der Durchmesser der Flächen (16) der 0,5- bis 5-fachen Dicke einer der Keramiklagen (2) des Aktors (1) entspricht, dass der minimale Abstand (17) der Flächen (16) ebenfalls der 0,5- bis 5-fachen Dicke der Keramiklagen (2) des Aktors (1) entspricht und dass eine durch die hintereinanderliegenden punktförmigen Flächen (16) verlaufende gerade Linie einen Winkel (18) zu dem Verlauf der Innenelektroden (10) einschließt, der etwa zwischen 10 Grad und 80 Grad, vorzugsweise zwischen 15 Grad und 40 Grad liegt.

9. Piezokeramischer Vielschichtaktor nach Anspruch 8, **dadurch gekennzeichnet, dass** der Durchmesser und der Abstand (17) der punktförmigen Flächen (16) der 2- bis 3-fachen Dicke einer der Keramiklagen (2) des Aktors (1) entsprechen.

10. Piezokeramische Vielschichtaktor nach einem der Ansprüche 1 bis 7, **dadurch gekennzeichnet, dass** die Struktur (15) der Grundmetallisierung (3) aus parallelen Linien strukturen (16) besteht, dass die Breite der Linien strukturen (16) der 0,5- bis 5-fachen Dicke einer der Keramiklagen (2) des Aktors (1) entspricht, dass der minimale Abstand (17) der Linien strukturen (16) ebenfalls der 0,5- bis 5-fachen Dicke einer der Keramiklagen (2) des Aktors (1) entspricht und dass der Schenkel eines Winkels, der durch eine Linienstruktur verläuft, einen Winkel (18) zu dem Verlauf der Innenelektroden (10) einschließt, der etwa zwischen 10 Grad und 80 Grad, vorzugsweise zwischen 15 Grad und 40 Grad liegt.

11. Piezokeramischer Vielschichtaktor nach Anspruch 10, **dadurch gekennzeichnet, dass** die Breite und der Abstand (17) der Linienstrukturen (16) der 2- bis 3-fachen Dicke einer der Keramiklagen (2) des Aktors (1) entsprechen.

12. Piezokeramischer Vielschichtaktor nach einem der Ansprüche 1 bis 7, **dadurch gekennzeichnet, dass** die Struktur (15) der Grundmetallisierung (3) aus gitternetzartig angeordneten Linienstrukturen (6) besteht, dass die Breite der Linienstrukturen (16) der 0,5- bis 5-fachen Dicke einer der Keramiklagen (2) des Aktors (1) entspricht, dass der minimale Abstand (17) der Linienstrukturen (16) ebenfalls der 0,5- bis 5-fachen Dicke einer der Keramiklagen (2) des Aktors (1) entspricht und dass die Linienstrukturen (16) des Gitternetzes (15) in einem beliebigen Winkel (18) zueinander und zu dem Verlauf der Innenelektroden (10) stehen.

13. Piezokeramischer Vielschichtaktor nach Anspruch 12, **dadurch gekennzeichnet, dass** die Breite und der Abstand (17) der Linienstrukturen (16) der 2- bis 3-fachen Dicke einer der Keramiklagen (2) des Aktors (1) entsprechen.

14. Piezokeramischer Vielschichtaktor nach einem der vorhergehenden Ansprüche, **dadurch gekennzeichnet, dass** die Verbindungsschicht (8) zwischen Grundmetallisierung (3) und Verstärkungsschicht (4) aus einem Lot besteht, das mindestens eines der Metalle Sn, Ag, Cu, Pb, Au, In, Ga aufweist.

15. Piezokeramischer Vielschichtaktor nach Anspruch 14, **dadurch gekennzeichnet, dass** das Lot ein zinnhaltiger Werkstoff ist, vorzugsweise SnAg₄ oder SnCu_{0,7}.

16. Piezokeramischer Vielschichtaktor nach einem der vorhergehenden Ansprüchen, **dadurch gekennzeichnet, dass** die Verbindungsschicht (8) zwischen Grundmetallisierung (3) und Verstärkungsschicht (4) ein elektrisch leitfähiger Klebstoff ist.

17. Verfahren zur Herstellung eines piezokeramischen Vielschichtaktors aus einem monolithischen, in einem Stück gefertigten Laminatgrundkörper, insbesondere nach einem der Ansprüche 1 bis 16, der aus sich abwechselnden Schichten von piezokeramischem Werkstoff mit dazwischenliegenden Innenelektroden aufgebaut wird, wobei an denjenigen Außenflächen de Laminatgrundkörpers, an denen die Innenelektroden alternierend an die Oberfläche treten, eine Grundmetallisierungsschicht aufgetragen wird, und darauf eine Verbindungsschicht aufgetragen wird, um eine darauf folgende Verstärkungsschicht mit der Grundmetallisierungsschicht zu verbinden, wobei an die Verstärkungsschicht ein Anschlussdraht angelötet wird, **dadurch gekennzeichnet, dass** vor dem Aufbringen der Verbindungsschicht die Grundmetallisierungsschicht eine durch Unterbrechungen und Ausnehmungen definierte Struktur aufweist.

18. Verfahren nach Anspruch 17, **dadurch gekennzeichnet, dass** die Struktur der Grundmetallisierung als Druckmuster mittels eines Druckverfahrens mit einer geeigneten Terminierungspaste erzeugt wird.

19. Verfahren nach Anspruch 17, **dadurch gekennzeichnet, dass** die Struktur der Grundmetallisierung durch einen mechanischen, chemischen oder elektrochemischen Abtrag in einer vollflächig aufgetragenen Schicht der Grundmetallisierung gebildet wird.

20. Verfahren nach Anspruch 18 oder 19, **dadurch gekennzeichnet, dass** die Grundmetallisierung aus einer geeigneten Terminierungspaste erzeugt wird, die die Zusammensetzung AgₓPd_{y} aufweist, wobei x + y = 1 und 1 > x > 0 sind, vorzugsweise aber 1 > x > 0,7 ist.

21. Verfahren nach Anspruch 17, **dadurch gekennzeichnet, dass** die Struktur der Grundmetallisierung durch eine poröse elektrochemische Abscheidung eines geeigneten metallischen Werkstoffs gebildet wird.

22. Verfahren nach Anspruch 21, **dadurch gekennzeichnet, dass** als metallischer Werkstoff Nickel verwendet wird.

23. Verfahren nach einem der Ansprüche 17 bis 22, **dadurch gekennzeichnet, dass** die Struktur der Grundmetallisierung aus über die Oberfläche des Aktors verteilte Flächen gebildet wird und dass mindestens so große Flächen erzeugt werden, dass jeweils benachbarte Innenelektroden durch mindestens eine Fläche miteinander verbunden werden.

24. Verfahren nach einem der vorhergehenden Ansprüche, **dadurch gekennzeichnet, dass** die Verstärkungsschicht auf die Grundmetallisierung aufgelötet wird, und das das Lot mindestens eines der Metalle Sn, Ag, Cu, Pb, Au, In, Ga aufweist.

25. Verfahren nach Anspruch 24, **dadurch gekennzeichnet, dass** das Lot ein zinnhaltiger Werkstoff ist, vorzugsweise SnAg₄ oder SnCu_{0,7}.

26. Verfahren nach Anspruch 24 oder 25, **dadurch gekennzeichnet, dass** durch die Unterbrechungen in der Struktur der Grundmetallisierung Metall aus dem Lot in die Innenelektroden einlegiert wird und dass der Keramikwerkstoff an diesen Stellen geschwächt wird, wodurch Vorzugsstellen für mögliche Rissbildungen und den Rissverlauf gebildet werden.

## Claims

1. A piezoceramic multilayer actuator (1), comprising a monolithic laminated parent body manufactured in one piece and built up of alternating layers of piezoceramic material (2), and intervening internal electrodes (10) and external electrodes (3, 4, 8) that are applied to those external areas of the laminated parent body at which the internal electrodes (10) alternately emerge at the surface of the laminated parent body and are composed of a basic metallization layer (3) directly on the surface of the laminated parent body and a reinforcing layer (4) that is joined directly onto the external area of the basic metallization layer (3) by means of an intervening joining layer (8), the basic metallization layer (3), the joining layer (8) and the reinforcing layer (4) being directly applied to one another in that order, and a connecting wire (5) being soldered onto the reinforcing layer (4), **characterized in that** the basic metallization layer (3) has a structure defined by discontinuities or recesses (17).

2. A piezoceramic multilayer actuator according to Claim 1, **characterized in that** the structure (15) of the basic metallization (3) is composed of a printed pattern of a suitable termination paste, which printed pattern has been produced by means of a printing method.

3. A piezoceramic multilayer actuator according to Claim 1, **characterized in that** the structure (15) of the basic metallization (3) is formed by a mechanical, chemical or electrochemical removal in a layer of the basic metallization (3) applied over the entire area.

4. A piezoceramic multilayer actuator according to Claim 2 or 3, **characterized in that** the basic metallization (3) is composed of a suitable termination paste that has the composition AgₓPd_{y}, where x + y = 1 and 1 > x > 0, but preferably 1 > x > 0.7.

5. A piezoceramic multilayer actuator according to Claim 1, **characterized in that** the structure (15) of the basic metallization (3) is formed by a porous electro-chemical deposition of a suitable metallic material.

6. A piezoceramic multilayer actuator according to Claim 5, **characterized in that** the metallic material is nickel.

7. A piezoceramic multilayer actuator according to one of Claims 1 to 6, **characterized in that** the structure (15) of the basic metallization (3) is composed of areas (16) disposed over the surface of the actuator (1) and **in that** the areas (16) are at least large enough for respective adjacent internal electrodes (10) to be joined together by at least one area (16).

8. A piezoceramic multilayer actuator according to any one of Claims 1 to 7, **characterized in that** the structure (15) of the basic metallization (3) is a matrix-like structure of punctiform areas (16), **in that** the diameter of the areas (16) is equal to 0.5 to 5 times the thickness of one of the ceramic layers (2) of the actuator (1), **in that** the minimum distance (17) between the areas (16) is likewise equal to 0.5 to 5 times the thickness of the ceramic layers (2) of the actuator (1), and **in that** a straight line extending through the punctiform areas (16) lying one behind the other encloses an angle (18) with respect to the path of the internal electrodes (10) that is approximately between 10 degrees and 80 degrees, preferably between 15 degrees and 40 degrees.

9. A piezoceramic multilayer actuator according to Claim 8, **characterized in that** the diameter of and the spacing (17) between the punctiform areas (16) are equal to 2 to 3 times the thickness of one of the ceramic layers (2) of the actuator (1).

10. A piezoceramic multilayer actuator according to any one of Claims 1 to 7, **characterized in that** the structure (15) of the basic metallization (3) is composed of parallel line structures (16), **in that** the width of the line structures (16) is equal to 0.5 to 5 times the thickness of one of the ceramic layers (2) of the actuator (1), **in that** the minimum distance (17) between the line structures (16) is likewise equal to 0.5 to 5 times the thickness of one of the ceramic layers (2) of the actuator (1), and **in that** the arm of an angle that extends through a line structure encloses an angle (18) with respect to the path of the internal electrodes (10) that is approximately between 10 degrees and 80 degrees, preferably between 15 degrees and 40 degrees.

11. A piezoceramic multilayer actuator according to Claim 10, **characterized in that** the width of and the spacing (17) between the line structures (16) are equal to 2 to 3 times the thickness of one of the ceramic layers (2) of the actuator (1).

12. A piezoceramic multilayer actuator according to any one of Claims 1 to 7, **characterized in that** the structure (15) of the basic metallization (3) is composed of line structures (16) disposed in grid-like manner, **in that** the width of the line structures (16) is equal to 0.5 to 5 times the thickness of one of the ceramic layers (2) of the actuator (1), **in that** the minimum distance (17) between the line structures (16) is likewise equal to 0.5 to 5 times the thickness of one of the ceramic layers (2) of the actuator (1), and **in that** the line structures (16) of the grid (15) are at a random angle (18) with respect to one another and to the path of the internal electrodes (10).

13. A piezoceramic multilayer actuator according to Claim 12, **characterized in that** the width of and the spacing (17) between the line structures (16) are equal to 2 to 3 times the thickness of one of the ceramic layers (2) of the actuator (1).

14. A piezoceramic multilayer actuator according to one of the preceding claims, **characterized in that** the joining layer (8) between basic metallization (3) and reinforcing layer (4) is composed of a solder that contains at least one of the metals Sn, Ag, Cu, Pb, Au, In, Ga.

15. A piezoceramic multilayer actuator according to Claim 14, **characterized in that** the solder is a tin-containing material, preferably SnAg₄ or SnCu_{0.7}.

16. A piezoceramic multilayer actuator according to any one of the preceding claims, **characterized in that** the joining layer (8) between basic metallization (3) and reinforcing layer (4) is an electrically conductive adhesive.

17. A method for producing a piezoceramic multilayer actuator from a monolithic laminated parent body manufactured in one piece, in particular according to any one of Claims 1 to 16, that is built up of alternating layers of piezoelectric material with intervening internal electrodes, wherein a basic metallization layer is applied to those external areas of the laminated parent body at which the internal electrodes alternately emerge at the surface and a joining layer is applied thereto in order to join a reinforcing layer following thereon to the basic metallization layer, and wherein a connecting wire is soldered onto the reinforcing layer, **characterized in that**, before the joining layer is deposited, the basic metallization layer has a structure defined by discontinuities and recesses.

18. A method according to Claim 17, **characterized in that** the structure of the basic metallization is produced as a printed pattern by means of a printing method using a suitable termination paste.

19. A method according to Claim 17, **characterized in that** the structure of the basic metallization is formed by a mechanical, chemical or electrochemical removal in a layer of the basic metallization applied over the entire area.

20. A method according to Claim 18 or 19, **characterized in that** the basic metallization is produced from a suitable termination paste that has the composition AgₓPd_{y}, where x + y = 1 and 1 > x > 0, but preferably 1 > x > 0.7.

21. A method according to Claim 17, **characterized in that** the structure of the basic metallization is formed by a porous electrochemical deposition of a suitable metallic material.

22. A method according to Claim 21, **characterized in that** nickel is used as metallic material.

23. A method according to any one of Claims 17 to 22, **characterized in that** the structure of the basic metallization is formed from areas distributed over the surface of the actuator and **in that** areas are produced that are at least large enough for respectively adjacent internal electrodes to be joined together by at least one area.

24. A method according to any one of the preceding claims, **characterized in that** the reinforcing layer is soldered onto the basic metallization, and **in that** the solder contains at least one of the metals Sn, Ag, Cu, Pb, Au, In, Ga.

25. A method according to Claim 24, **characterized in that** the solder is a tin-containing material, preferably SnAg₄ or SnCu_{0.7}.

26. A method according to Claim 24 or 25, **characterized in that** metal from the solder is alloyed into the internal electrodes by the discontinuities in the structure of the basic metallization, and **in that** the ceramic material is weakened at these points, as a result of which preferred points are formed for possible crack formation and the crack path.

## Revendications

1. Actionneur piézocéramique multicouche (1) constitué d'un corps de base stratifié monolithique, réalisé d'une seule pièce et formé de couches alternantes d'un matériau piézocéramique (2) et d'électrodes intérieures (10) intercalées et d'électrodes extérieures (3, 4, 8) qui sont appliquées sur les faces extérieures du corps de base stratifié sur lesquelles les électrodes intérieures (10) sortent en alternance à la surface du corps de base stratifié et sont constituées d'une couche de métallisation de base (3), se trouvant directement sur la surface du corps de base stratifié, et d'une couche de renforcement (4), qui est reliée à la face extérieure de la couche de métallisation de base (3) à l'aide d'une couche de liaison (8) intermédiaire, la couche de métallisation de base (3), la couche de liaison (8) et la couche de renforcement (4) étant appliquées directement les unes sur les autres , dans cet ordre, et un fil de connexion (5) étant brasé à la couche de renforcement (4), **caractérisé en ce que** la couche de métallisation de base (3) présente une structure définie par des discontinuités ou des creux (17).

2. Actionneur piézocéramique multicouche selon la revendication 1, **caractérisé en ce que** la structure (15) de la métallisation de base (3) est formée d'un motif d'impression d'une pâte de terminaison appropriée, qui a été réalisé au moyen d'un procédé d'impression.

3. Actionneur piézocéramique multicouche selon la revendication 1, **caractérisé en ce que** la structure (15) de la métallisation de base (3) est formée par enlèvement mécanique, chimique ou électrochimique, dans une couche de la métallisation de base (3) appliquée sur toute la surface.

4. Actionneur piézocéramique multicouche selon la revendication 2 ou 3, **caractérisé en ce que** la métallisation de base (3) est constituée d'une pâte de terminaison appropriée, qui présente la composition AgₓPd_{y}, avec x + y = 1 et 1 > x > 0, mais de préférence 1 > x > 0,7.

5. Actionneur piézocéramique multicouche selon la revendication 1, **caractérisé en ce que** la structure (15) de la métallisation de base (3) est formée par séparation électrochimique poreuse d'un matériau métallique approprié.

6. Actionneur piézocéramique multicouche selon la revendication 5, **caractérisé en ce que** le matériau métallique est le nickel.

7. Actionneur piézocéramique multicouche selon une des revendications 1 à 6, **caractérisé en ce que** la structure (15) de la métallisation de base (3) est constituée de surfaces (16) réparties sur la surface de l'actionneur (1) et **en ce que** les surfaces (16) sont au moins suffisamment grandes pour que des électrodes intérieures (10) voisines soient reliées entre elles par au moins une surface (16).

8. Actionneur piézocéramique multicouche selon une des revendications 1 à 7, **caractérisé en ce que** la structure (15) de la métallisation de base (3) est une structure en forme de trame constituée de structures (16) ponctuelles, **en ce que** le diamètre des surfaces (16) est de 0,5 à 5 fois l'épaisseur de l'une des couches en céramique (2) de l'actionneur (1), **en ce que** l'espacement (17) minimal entre les surfaces (16) est également de 0,5 à 5 fois l'épaisseur de l'une des couches en céramique (2) de l'actionneur (1) et **en ce qu'**une ligne droite qui passe par des surfaces (16) ponctuelles disposées les unes à la suite des autres forme un angle (18) avec l'orientation des électrodes intérieures (10) qui est compris entre environ 10 degrés et 80 degrés, de préférence entre 15 et 40 degrés.

9. Actionneur piézocéramique multicouche selon la revendication 8, **caractérisé en ce que** le diamètre et l'espacement (17) des surfaces (16) ponctuelles sont compris entre 2 à 3 fois l'épaisseur de l'une des couches en céramique (2) de l'actionneur (1).

10. Actionneur piézocéramique multicouche selon une des revendications 1 à 7, **caractérisé en ce que** la structure (15) de la métallisation de base (3) est formée de structures (16) linéaires parallèles, **en ce que** la largeur des structures (16) linéaires est de 0,5 à 5 fois l'épaisseur de l'une des couches en céramique (2) de l'actionneur (1), **en ce que** l'espacement (17) minimal entre les structures (16) linéaires est également de 0,5 à 5 fois l'épaisseur de l'une des couches en céramique (2) de l'actionneur (1) et **en ce que** le côté d'un angle qui passe par une structure linéaire forme un angle (18) avec l'orientation des électrodes intérieures (10) qui est compris entre environ 10 degrés et 80 degrés, de préférence entre 15 et 40 degrés.

11. Actionneur piézocéramique multicouche selon la revendication 10, **caractérisé en ce que** la largeur et l'espacement (17) des structures (16) linéaires sont de 2 à 3 fois l'épaisseur de l'une des couches en céramique (2) de l'actionneur (1).

12. Actionneur piézocéramique multicouche selon une des revendications 1 à 7, **caractérisé en ce que** la structure (15) de la métallisation de base (3) est constituée de structures (16) linéaires disposées sous forme de quadrillage, **en ce que** la largeur des structures (16) linéaires est de 0,5 à 5 fois l'épaisseur de l'une des couches en céramique (2) de l'actionneur (1), **en ce que** l'espacement (17) minimal entre les structures (16) linéaires est également de 0,5 à 5 fois l'épaisseur de l'une des couches en céramique (2) de l'actionneur (1) et **en ce que** les structures (16) linéaires du quadrillage (15) forment n'importe quel angle (18) entre elles et avec l'orientation des électrodes intérieures (10).

13. Actionneur piézocéramique multicouche selon la revendication 12, **caractérisé en ce que** la largeur et l'espacement (17) des structures (16) linéaires sont de 2 à 3 fois l'épaisseur de l'une des couches en céramique (2) de l'actionneur (1).

14. Actionneur piézocéramique multicouche selon une des revendications précédentes, **caractérisé en ce que** la couche de liaison (8) entre la métallisation de base (3) et la couche de renforcement (4) est formée d'une brasure qui présente au moins l'un des métaux englobant Sn, Ag, Cu, Pb, Au, In, Ga.

15. Actionneur piézocéramique multicouche selon la revendication 14, **caractérisé en ce que** la brasure est un matériau à base d'étain et est de préférence SnAg₄ ou SnCu_{0,7}.

16. Actionneur piézocéramique multicouche selon une des revendications précédentes, **caractérisé en ce que** la couche de liaison (8) entre la métallisation de base (3) et la couche de renforcement (4) est un adhésif conducteur de l'électricité.

17. Procédé de fabrication d'un actionneur piézocéramique multicouche à partir d'un corps de base stratifié monolithique, réalisé d'une seule pièce, en particulier selon une des revendications 1 à 16, qui est constitué de couches alternantes d'un matériau piézocéramique et d'électrodes intérieures intercalées, une couche de métallisation de base étant appliquée sur les faces extérieures du corps de base stratifié où les électrodes intérieures sortent en alternance à la surface, et une couche de liaison étant appliquée sur ladite couche pour relier une couche de renforcement, qui suit, à la couche de métallisation de base, un fil de connexion étant brasé à la couche de renforcement, **caractérisé en ce que**, avant l'application de la couche de liaison, la couche de métallisation de base présente une structure définie par des discontinuités et des creux.

18. Procédé selon la revendication 17, **caractérisé en ce que** la structure de la métallisation de base est réalisée sous la forme d'un motif d'impression avec une pâte de terminaison appropriée, au moyen d'un procédé d'impression.

19. Procédé selon la revendication 17, **caractérisé en ce que** la structure de la métallisation de base est formée par enlèvement mécanique, chimique ou électrochimique, dans une couche de la métallisation de base appliquée sur toute la surface.

20. Procédé selon la revendication 18 ou 19, **caractérisé en ce que** la métallisation de base est réalisée à partir d'une pâte de terminaison appropriée, qui présente la composition AgₓPd_{y}, avec x + y = 1 et 1 > x > 0, mais de préférence 1 > x > 0,7.

21. Procédé selon la revendication 17, **caractérisé en ce que** la structure de la métallisation de base est formée par séparation électrochimique poreuse d'un matériau métallique approprié.

22. Procédé selon la revendication 21, **caractérisé en ce que** le matériau métallique utilisé est le nickel.

23. Procédé selon une des revendications 17 à 22, **caractérisé en ce que** la structure de la métallisation de base est constituée de surfaces réparties sur la surface de l'actionneur et **en ce que** les surfaces créées sont au moins suffisamment grandes pour que des électrodes intérieures mutuellement voisines soient reliées entre elles par au moins une surface.

24. Procédé selon une des revendications précédentes, **caractérisé en ce que** la couche de renforcement est appliquée par brasage sur la couche de métallisation de base et **en ce que** la brasure présente au moins l'un des métaux englobant Sn, Ag, Cu, Pb, Au, In, Ga.

25. Procédé selon la revendication 24, **caractérisé en ce que** la brasure est un matériau à base d'étain et est de préférence SnAg₄ ou SnCu_{0,7}.

26. Procédé selon la revendication 24 ou 25, **caractérisé en ce que**, à travers les discontinuités dans la structure de la métallisation de base, du métal contenu dans la brasure est introduit par alliage dans les électrodes intérieures et **en ce que** le matériau céramique est affaibli à ces endroits, créant ainsi des endroits préférentiels pour d'éventuelles fissurations et le tracé des fissures.
